Europäisches Patentamt

(19) European Patent Office

Office européen des brevets

(11) Numéro de publication : **0 068 975**
**B1**

(12) **FASCICULE DE BREVET EUROPÉEN**

(45) Date de publication du fascicule du brevet :
24.04.85

(51) Int. Cl.⁴ : **H 01 L 27/14, H 01 L 29/78**

(21) Numéro de dépôt : **82401092.0**

(22) Date de dépôt : **15.06.82**

(54) Détecteur photonique à lecture à transfert de charges à l'état solide, et cible de prise de vues utilisant un tel détecteur.

(30) Priorité : 30.06.81 FR 8112841

(43) Date de publication de la demande :
05.01.83 Bulletin 83/01

(45) Mention de la délivrance du brevet :
24.04.85 Bulletin 85/17

(84) Etats contractants désignés :
DE GB NL

(56) Documents cités :
US-A- 4 087 833
US-A- 4 112 316
US-A- 4 150 304
IEEE JOURNAL OF SOLID-STATE CIRCUITS, vol.CS-13, no.1, février 1978, IEEE, New York (US), J.T. LONGO et al.: "Infrared focal planes in intrinsic semiconductors", pages 139-158
IEEE TRANSACTIONS ON ELECTRON DEVICES, vol.ED-27, no.1, janvier 1980, IEEE, New York (US), P. FELIX et al.: "CCD readout of infrared hybrid focal-plane arrays", pages 175-188

(73) Titulaire : **THOMSON-CSF**
**173, Boulevard Haussmann**
**F-75379 Paris Cedex 08 (FR)**

(72) Inventeur : **Arques, Marc**
**THOMSON-CSF SCPI 173, bld Haussmann**
**F-75379 Paris Cedex 08 (FR)**

(74) Mandataire : **Mayeux, Michèle et al**
**THOMSON-CSF SCPI 173, Bld Haussmann**
**F-75379 Paris Cedex 08 (FR)**

## Description

L'invention concerne un ensemble formé par un détecteur de rayonnement et son système de lecture à transfert de charges.

Un tel ensemble est utilisé à l'élaboration d'images de rayonnements incidents, infrarouge notamment.

L'invention concerne en particulier le cas où les détecteurs, ou capteurs, et les lecteurs, réalisés à l'état solide, consistent en des diodes photovoltaïques ou photodiodes, d'une part et, d'autre part, en des lecteurs à transfert de charges (DTC) — CCD dans la littérature de langue anglaise — aujourd'hui bien connus, dans lesquels le signal à lire est transféré de proche en proche vers le registre de lecture. Ce signal est ici celui des charges libres engendrées dans la diode par le rayonnement reçu. L'invention sera décrite à titre non limitatif, dans le cas de telles diodes.

Généralement, dans de tels ensembles, on fait en sorte que les charges porteuses du signal, c'est-à-dire celles en provenance de la photodiode, et celles mises en œuvres dans le transfert de charges soient de même signe. Mais il peut arriver, pour des raisons technologiques, que la situation soit inversée et que ces charges soient de signes contraires. Un problème se pose alors pour assurer la lecture du signal ; c'est à la solution de celui-ci que l'invention est consacrée, dans les conditions qui vont être exposées.

L'invention sera mieux comprise en se reportant à la description qui suit et aux figures jointes qui représentent :

figures 1 (a, b) et figures 2 (a, b)  des schémas montrant les diverses situations rencontrées dans les ensembles auxquels s'applique l'invention ;

figure 3 (a, b)  les schémas des figures 2 (a) et 2 (b) tels que modifiés par l'invention ;

figures 4 et 5  une vue schématique d'une première variante de l'invention et un diagramme des potentiels s'y rapportant, respectivement ;

figures 6 et 7 (a-d)  les mêmes figures pour une autre variante de l'invention ;

figure 8  un diagramme complémentaire de celui des figures 7 précédentes ;

figure 9  une vue schématique d'une version modifiée de la variante de la figure 6.

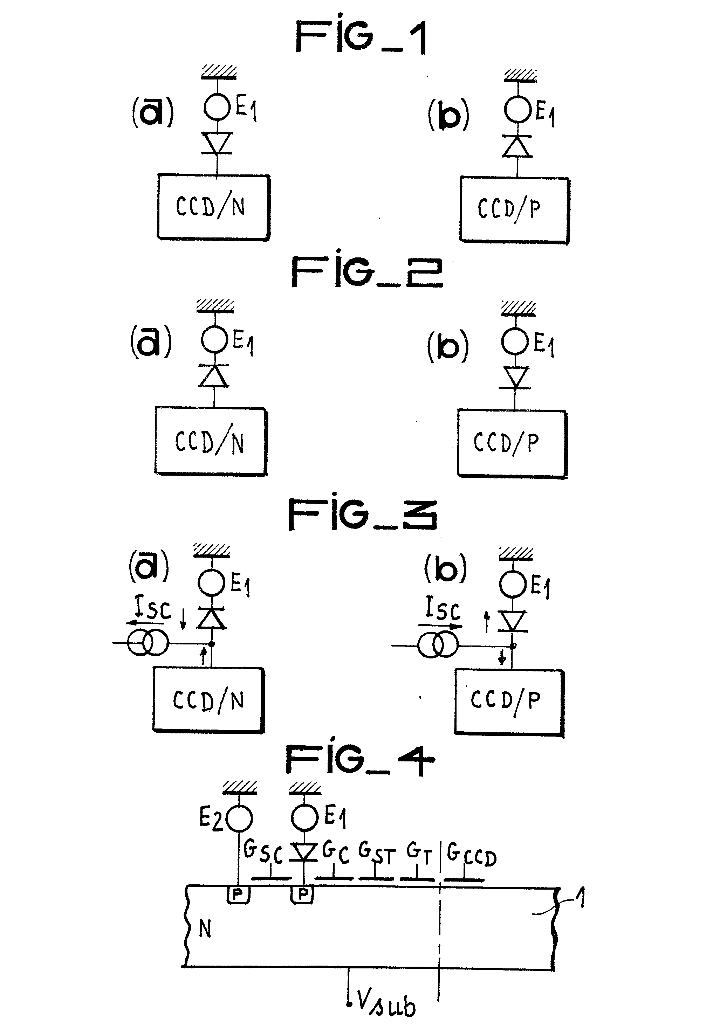

Sur les schémas des figures 1 (a, b) et 2 (a, b), sont représentées de manière conventionnelle une diode sans repère et son alimentation continue E1 ; cette diode est la diode photovoltaïque de ce qui précède, fournissant le signal qui correspond aux photons incidents ; le lecteur à transfert de charges est représenté par un rectangle marqué par les lettres CCD et une lettre supplémentaire indiquant le signe des charges de transfert : N pour les électrons et P pour des « trous ». Dans le cas des figures 1, la photodiode, montée comme indiqué, fournit un signal formé de charges du même signe que celles mises en œuvres dans le transfert, à savoir des électrons dans le cas de la figure 1 (a) et des « trous » dans celui de la figure 1 (b). Dans la disposition des figures 2 c'est l'inverse ; les charges du signal et celles du transfert sont de signe opposé, comme cela se déduit des dessins, comparés à ceux des figures 1 (a, b). C'est aux situations des figures 2 que s'applique l'invention, et cela quel que soit le signe des charges de transfert, négatif (électrons) ou positif (« trous »). Les raisons qui font que ces situations peuvent se présenter tiennent au fait que la photodiode et le lecteur sont ordinairement réalisés dans deux matériaux différents, le lecteur à transfert de charges généralement dans un substrat de silicium à canal de type N, c'est-à-dire dans lequel les charges de transfert sont des électrons, et la photodiode, dans un substrat en antimoniure d'indium, In Sb par exemple, pour fonctionnement en infrarouge. D'autre part, à cause de contraintes essentiellement technologiques, il arrive qu'on ne puisse avoir accès qu'à l'une des bornes de la photodiode (anode ou cathode) pour la liaison avec le dispositif à transfert de charges, l'autre borne étant reliée à la source de tension. On pourrait ainsi se trouver dans la situation de la figure 2 (a) ou être dans celle de la figure 2 (b) si, pour des raisons particulières, on avait choisi un canal de type P dans le silicium en question.

Pour résoudre le problème exposé, il est connu, ainsi que décrit dans US-A-4 112 316 d'ajouter une source de courant, comme indiqué sur les figures 3 (a, b) dans les deux situations objet des figures 2 (a) et 2 (b). Cette source de courant ne porte pas de repère sur les dessins ; par contre sont indiqués, par des flèches, les sens des courants mis en œuvre selon les conventions habituelles en électricité, où le sens du courant est opposé à celui du déplacement des électrons. Le courant supplémentaire fourni par cette source est désigné par $I_{SC}$. Pour résoudre la difficulté exposée, il est nécessaire que ce courant $I_{SC}$ soit supérieur, en valeur absolue, au courant d'origine photonique qui circule dans la photodiode, de façon que se trouvent injectés dans le lecteur des porteurs du signe de ceux qui y assurent la conduction. Il est à noter que le courant lu sera dans ce cas un courant complémentaire, de la forme a-s, si s est le courant de signal de la photodiode et a le courant total fourni par la source pendant la période d'intégration ; ce courant a-s est tout aussi représentatif du signal que le courant s lui-même. Toutefois, cette source de courant est extérieure au dispositif de lecture à transfert de charges.

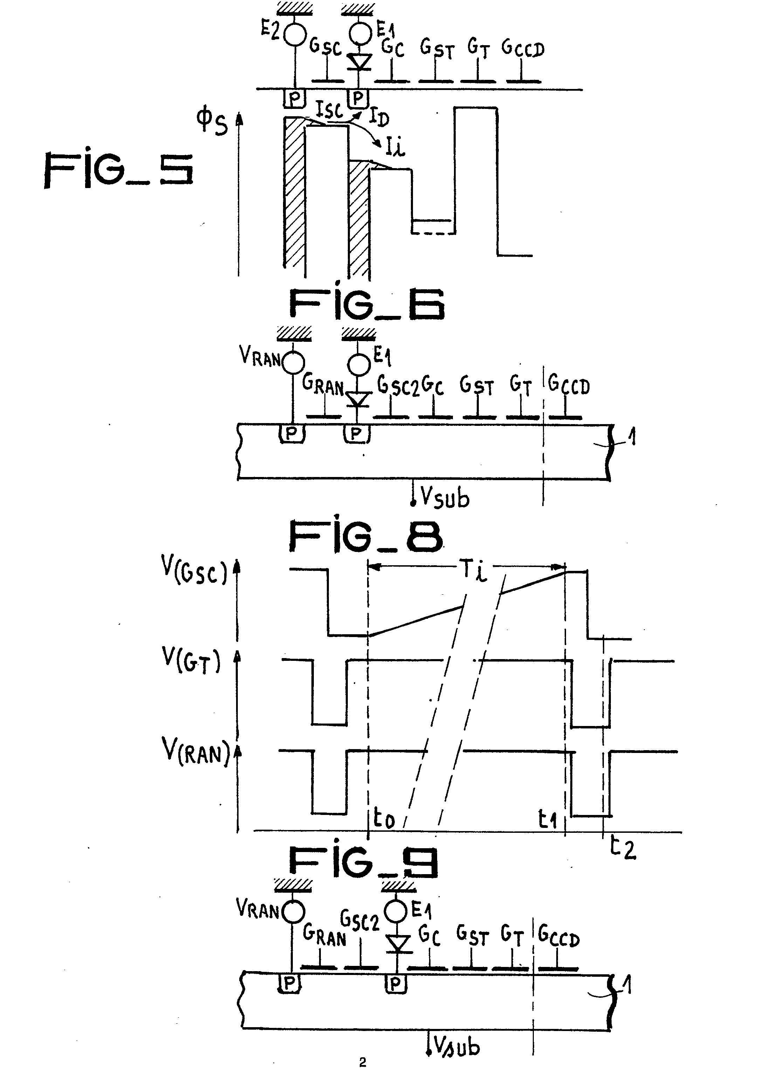

Conformément à la présente invention et à la revendication 1 pour accroître l'intégration, la source de courant est réalisée sur le même substrat que le dispositif de lecture à transfert de charges. Dans une première variante de l'invention, la source de courant est réalisée au moyen d'une zone dopée P formée dans le substrat 1 de type N, reliée à une source de tension $E_2$, et d'une grille $G_{SC}$, comme le montre la figure 4. L'indice SC a été choisi pour marquer l'appartenance de cette grille à la source de courant.

On rappelle que, dans ce cas, les charges transférées sont des « trous » c'est-à-dire des charges positives. L'ensemble est dit à canal de type P et correspond à la situation de la figure 3(b).

Le substrat est polarisé à la tension $V_{sub}$.

La figure 4 montre, en outre les éléments de la transition, telle qu'elle se présente habituellement, ménagée entre la photodiode et l'entrée du lecteur à transfert de charges, représenté par sa première grille, marquée $G_{CCD}$. Cette transition consiste en un transistor MOS, dont la source est la zone dopée P la plus à droite de la figure, reliée à la photodiode, dont l'électrode de commande est la grille $G_C$ et dont le drain, en quelque sorte, est la grille $G_{ST}$, sous laquelle a lieu le stockage des charges de signal avant leur injection dans le dispositif à transfert de charges, au-delà de la ligne en trait mixte.

Les deux zones P et la grille $G_{SC}$ forment un transistor, maintenu en état de saturation. Ce transistor équivaut à une source de courant, le courant de cette source étant le courant $I_{SC}$ de la figure précédente. La photodiode prélève sur ce courant une partie $I_D$ pour la compensation des charges de signe contraire à celles des charges de transfert dans le dispositif de lecture. Il en reste la fraction $I_i$, donnée par la formule :

$$I_i = I_{SC} - | I_D |, \qquad (1)$$

qui est celle de la répartition des courants dans les schémas 3, fraction formée de charges ayant le signe voulu pour ce transfert. L'état de saturation précédent est nécessaire pour éviter des fluctuations dans le débit du transistor P, $G_{SC}$, P, dues au courant qu'il pourrait recevoir de la photodiode.

Le courant $I_i$ est stocké sous la grille $G_{ST}$ et intégré sous cette grille pendant toute la période d'intégration. La charge résultante est périodiquement transférée dans le lecteur en débloquant le canal sous la grille $G_T$.

La figure 5 montre l'état des potentiels de surface $\Phi_S$ sous les différentes grilles lors du transfert des charges du courant $I_i$ sous la grille de stockage $G_{ST}$.

Dans la représentation adoptée, les traits pleins représentent les potentiels de surface régnant effectivement sous les différentes électrodes, tandis que les traits interrompus représentent ce que seraient ces mêmes potentiels si les « puits de potentiel », suivant la terminologie admise en la matière, étaient vides de charges ; les surfaces couvertes de hachures représentent les quantités de charges présentes dans les puits ; enfin, pour la clarté, les différentes grilles ont été figurées sans chevauchement les unes par rapport aux autres ; en réalité deux grilles successives peuvent se recouvrir partiellement ; pour les mêmes raisons de clarté, on n'a pas représenté la couche d'isolant séparant le substrat des diverses grilles. L'axe des potentiels $\Phi_S$ est orienté positivement vers le haut de la figure, en accord avec le fait que le substrat est à canal P et les charges mobiles des « trous ».

On remarquera, qu'étant donnée la forme de la grandeur du signal utilisé, a − s comme on l'a dit plus haut, ou $I_i$ suivant la formule (1), dans le dispositif de l'invention, plus le signal de la photodiode (s ou $I_D$ dans ce qui précède) augmente et plus cette grandeur de signal, c'est-à-dire le signal injecté dans le lecteur diminue. Il y a dans le dispositif de l'invention un effet d'auto-compensation des surcharges, comme celle résultant d'un sur-éclairement de la photodiode par exemple.

Le signal injecté dans le lecteur peut même devenir nul lorsque le terme $I_D$ devient suffisamment grand pour annuler le second membre de l'équation (1) ; pour tout éclairement de la photodiode correspondant à cette valeur, ou supérieur, il y a écrêtage du signal lu à la sortie du dispositif à transfert de charges et en aucun cas éblouissement.

On remarquera également que la présence du courant $I_{SC}$, lorsqu'il est suffisamment élevé, améliore les conditions de transmission du signal de la photodiode dans le lecteur à transfert de charges. On sait, en effet, que le rendement d'injection de ce signal dépend des valeurs relatives des impédances de la photodiode et de la transition MOS. En basse fréquence, il croît avec la transconductance du MOS de transition, pour une résistance donnée de la photodiode, laquelle transconductance est elle-même une fonction croissante du courant mis en jeu dans la transmission du signal, à savoir le courant $I_i$ précédent. On notera encore, comme expliqué précédemment, qu'avec le choix qui est fait de la grandeur signal ce rendement d'injection est d'autant meilleur que l'éclairement, c'est-à-dire la quantité $I_D$ de la formule (1), est faible.

Les scènes faiblement éclairées sont mieux transmises que les scènes à fort éclairement.

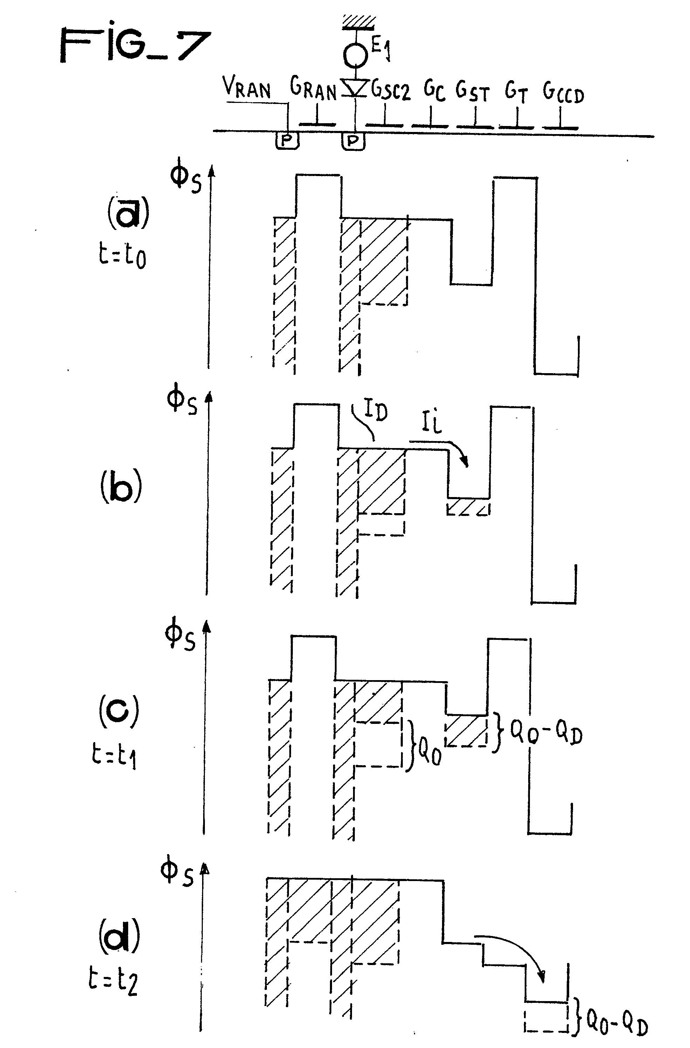

Dans une autre variante de l'invention, représentée sur la figure 6, la source de courant comprend une grille $G_{SC2}$ dont on précisera le rôle à l'aide des figures 7.

Dans l'exemple de réalisation de la figure 6, une grille $G_{SC2}$ est disposée sur le substrat 1 à droite de la zone P reliée à la photodiode, l'indice qui la désigne étant, comme pour la grille $G_{SC}$ de la figure 4 dû à sa participation à la création de courant, bien que, comme on va le voir, elle y participe de façon différente. La source $E_2$, est désignée sur cette figure par la différence de potentiel $V_{RAN}$, apparaissant, en fonctionnement, entre ses bornes, et la grille $G_{SC}$ de la figure 4 précédente par $G_{RAN}$ (« RAN » pour remise à niveau). L'ensemble fonctionne comme il va être indiqué ci-dessous, à l'aide des figures 7 (a-d).

Le transistor MOS, P, $G_{RAN}$, P fonctionne cette fois, en régime linéaire dans sa phase active ; il est bloqué le reste du temps.

Le puits de potentiel sous $G_{SC2}$ est rempli par les charges du transistor constitué par les deux diffusions P et la grille $G_{RAN}$, polarisée à la tension $V_{RAN}$.

Après avoir bloqué le canal sous la grille $G_{RAN}$

à l'instant initial $t = t_0$ (figure 7 (a)), on diminue la contenance du puits de potentiel sous $G_{SC2}$ en diminuant le potentiel appliqué à $G_{SC2}$ (figure 7 (b)). L'excédent de charges sous $G_{SC2}$ déverse dans le puits sous $G_{ST}$ un courant qui, comme dans l'exemple précédent, est égal à $I_{SC}$ diminué du courant $I_D$ absorbé par la photodiode suivant la formule (1). Lorsque la contenance du puits sous la grille $G_{SC2}$ est à sa valeur minimale au temps $t = t_1$, séparé de l'instant $t_0$, éventuellement, par la durée de la période d'intégration $T_i$, comme on le verra, on se trouve dans la situation de la figure 7 (c). On ramène le puits sous $G_{SC2}$ à sa profondeur initiale et on le remplit de nouveau, en débloquant le canal sous la grille $G_{RAN}$, à l'instant $t = t_2$. Le dispositif est prêt pour le cycle suivant. Les lettres $Q_0$ et $Q_D$ désignent sur le diagramme de la figure 7 les quantités de charges résultant pendant le cycle des courants $I_{SC}$ et $I_D$ précédents.

Si l'on voulait se livrer à une comparaison entre les deux variantes décrites, on pourrait dire que, dans un cas comme dans l'autre, il y a création de courant par un MOS convenablement polarisé formé dans le substrat du lecteur, mais que dans un cas, celui de la première variante, ce courant s'écoule de façon continue vers la grille de stockage $G_{ST}$, d'où les charges sont ensuite transférées vers le lecteur, alors que dans l'autre cas, au contraire, il y a un premier stockage des charges sous la grille $G_{SC2}$, avant le stockage sous $G_{ST}$ ; à chaque cycle on assure le transfert du résultat de ce premier stockage vers la grille $G_{ST}$ qui fonctionne comme dans le cas précédent.

Le transfert des charges sous la grille $G_{ST}$ peut s'effectuer de façons diverses dans le cadre de l'invention. Suivant un mode préféré, il a lieu par application d'une tension décroissant régulièrement dans le temps à l'électrode $G_{SC2}$, suivant le diagramme de la figure 8, montrant également les tensions appliquées au cours d'un cycle aux électrodes $G_T$ de transfert dans le lecteur, et $G_{RAN}$ de remise à niveau. Dans l'exemple de la figure, la rampe de tension appliquée à l'électrode $G_{SC2}$ correspond au cas d'une décroissance linéaire en valeur absolue ; sa pente positive correspond à des charges libres consistant en des « trous » conformément à ce qui précède. On a coupé le diagramme des temps de la figure 8, afin de respecter les proportions des durées des différentes phases, l'intervalle $t_1$ $t_2$ étant en général une faible fraction de $T_i$, de l'ordre du dixième ou moins. On agit sur le courant $I_{SC}$ en jouant sur la pente de la rampe précédente.

L'injection des charges stockées sous $G_{ST}$ dans le lecteur, commandée par la grille $G_T$, a lieu périodiquement à une fréquence qui détermine la période d'intégration $T_i$ dont il a été question ; cette fréquence est en général très inférieure à celle à laquelle le lecteur est lui-même vidé de ses informations, car le plus souvent on ne dispose que d'un registre pour lire l'un après l'autre les signaux de plusieurs photodiodes tous injectés en même temps dans le lecteur, à la fin de chaque période d'intégration. Quant à la fréquence à laquelle se fait le transfert des charges de $G_{SC2}$ sous $G_{ST}$ suivant le cycle décrit, elle peut être, elle, très différente de la fréquence à laquelle est commandée $G_T$. Si la capacité du puits sous $G_{SC2}$ est plus petite que celle du puits sous $G_{ST}$ on peut répéter plusieurs fois le transfert $G_{SC2}$ vers $G_{ST}$ avant de vider le puits sous $G_{ST}$ ; la fréquence à laquelle on agit sur $G_{SC2}$ peut donc être supérieure à celle à laquelle on agit sur $G_T$, et inversement, elle peut être inférieure, lorsque c'est la capacité sous $G_{SC2}$ qui est plus grande que celle sous $G_{ST}$. Il n'y a pas de relation imposée entre ces fréquences. Dans le cas des figures 7 on les a choisies égales ; le transfert dans le lecteur est effectué au temps $t_2$.

Les fréquences de commutation des potentiels des électrodes $G_{RAN}$ et $G_{SC2}$ sont, elles, toujours égales.

Les remarques précédentes, concernant l'auto-protection contre les surcharges et l'effet favorable du courant $I_{SC}$ sur le rendement d'injection s'appliquent au cas de cette variante.

On signalera par contre une différence entre les deux variantes en ce qui concerne le traînage consécutif à un sur-éclairement ; dans le cas de la première variante on observe un traînage dû au temps nécessaire pour que la diode revienne à son point de fonctionnement, qui s'était déplacé sous l'effet de cette surcharge, vers une valeur telle que le courant $I_D$ diminue jusqu'à devenir égal à $I_{SC}$. Ce déplacement se fait vers le point de fonctionnement en circuit ouvert de la photodiode ; celle-ci n'est donc exposée à aucun dommage du fait de ce sur-éclairement. Dans le cas de la seconde variante, un tel traînage n'existe pas, car le point de fonctionnement de la diode est réajusté au début de chaque cycle.

Dans une variante à la disposition précédente, la grille $G_{SC2}$ est placée entre les deux diffusions P, à la suite de la grille $G_{RAN}$.

Cette variante est représentée sur la figure 9. Son fonctionnement est le même que celui de la variante de la figure 6.

On citera comme matériau du lecteur à transfert de charges, outre le silicium, déjà nommé, l'arséniure de gallium.

Quant au matériau de la photodiode, on mentionnera parmi ceux le plus couramment utilisés, outre l'antimoniure d'indium, les tellurures de cadmium mercure, Hg Cd Te et d'étain plomb, Pb Sn Te pour l'infrarouge entre 3 et 12 microns de longueur d'onde.

Dans des exemples de réalisation de l'invention, les tellurures sont associés à des lecteurs à canal P, l'antimoniure d'indium avec des lecteurs à canal N.

L'invention est de réalisation facile ; les éléments supplémentaires prévus sont facilement intégrables dans le substrat du lecteur à transfert de charges.

Elle trouve une application dans la prise de vues en infrarouge, pour la réalisation de cibles comportant une série de photodiodes disposées le long de barrettes ou à la surface d'une mosaïque.

L'invention a été décrite dans le cas d'un substrat de type N, à canal de type P correspondant à la figure 3 (b). Il va sans dire qu'elle s'applique aussi bien au cas de la figure 3 (a), avec un canal de type N, moyennant tous les changements nécessaires, accessibles à l'homme de l'art.

**Revendications**

1. Détecteur photonique à lecteur à transfert de charges à l'état solide, dont le signal est injecté dans le lecteur $G_{(CCD)}$ par une transition consistant en un transistor MOS (P, $G_C$, $G_{ST}$), les charges de transfert mises en jeu dans le lecteur étant de signe opposé à celles de ce signal, comprenant des moyens engendrant un courant $I_{SC}$ fait de charges de même signe que les charges de transfert, et des moyens d'injection de ce courant dans ladite transition caractérisé en ce que les moyens engendrant le courant $I_{SC}$ sont réalisés par un second transistor MOS convenablement polarisé, intégré dans le même substrat que le lecteur et juxtaposé au précédent.

2. Détecteur photonique suivant la revendication 1, caractérisé en ce que les moyens engendrant le courant $I_{SC}$ consistent en un second transistor MOS juxtaposé au précédent sur le substrat (1) de celui-ci, constitué par la zone (P) dopée du substrat à laquelle est connecté le détecteur, dite première zone dopée, par une seconde zone (P) dopée formée dans ce substrat, et par une électrode de grille $G_{SC}$ disposée entre ces deux zones, et en ce qu'il comporte les moyens pour maintenir en fonctionnement ce deuxième transistor MOS dans l'état de saturation.

3. Détecteur photonique suivant la revendication 1, caractérisé en ce que les moyens engendrant le courant $I_{SC}$ consistent en un second transistor MOS juxtaposé au précédent sur le substrat (1) de celui-ci, constitué par la zone (P) dopée du substrat à laquelle est connecté le détecteur, dite première zone dopée, par une seconde zone P dopée formée dans ce substrat et par une électrode de grille $G_{RAN}$ disposée entre ces deux zones, en ce qu'il comporte des moyens pour polariser, en fonctionnement, ce deuxième transistor alternativement en régime linéaire, et en régime bloqué, et en ce qu'il comporte une seconde électrode de grille $G_{SC2}$ appliquée sur le substrat, et des moyens pour appliquer, en fonctionnement, à cette grille une tension suivant une rampe régulièrement variable dans le temps, éventuellement une ou plusieurs fois dans l'intervalle de temps qui sépare deux transferts successifs du signal, de la transition dans le lecteur.

4. Détecteur photonique suivant la revendication 3, caractérisé en ce que la seconde électrode de grille $G_{SC2}$ est placée à côté de l'électrode de grille $G_{RAN}$ entre les deux zones P.

5. Détecteur photonique suivant la revendication 3, caractérisé en ce que la seconde électrode de grille $G_{SC2}$ est placée de l'autre côté de l'électrode de grille $G_{RAN}$ par rapport à la seconde zone P.

6. Détecteur photonique suivant la revendication 3, caractérisé en ce que la rampe de tension est linéairement variable.

7. Détecteur photonique suivant l'une des revendications 1 à 6, caractérisé en ce qu'il consiste en une diode photovoltaïque.

8. Cible de prise de vues, caractérisée en ce qu'elle comprend au moins un détecteur suivant l'une des revendications 1 à 7.

**Claims**

1. Photonic detector with solid state charge transfer reader, the signal of which is injected into the reader $G_{(CCD)}$ through a transition consisting of a MOS transistor (P, $G_C$, $G_{ST}$), the transfer charges used in the reader having a sign opposite to those of this signal, comprising means generating a current $I_{SC}$ made up of charges of the same sign as the transfer charges, and means for injecting this current into said transition, characterized in that the means generating the current $I_{SC}$ are formed by a second MOS transistor appropriately biased and integrated into the same substrate as the reader, and being juxtaposed to the former.

2. Photonic detector according to claim 1, characterized in that the means generating the current $I_{SC}$ consist of a second MOS transistor juxtaposed to the former on the substrate (1) thereof, made up of the doped zone (P) whereto the detector is connected and called the first doped zone, of a second doped zone (P) formed within this substrate and of a gate electrode $G_{SC}$ arranged between these two zones, and in that it comprises means for maintaining, in operation, this second MOS transistor in the state of saturation.

3. Photonic detector according to claim 1, characterized in that the means generating the current $I_{SC}$ consist of a second MOS transistor juxtaposed to the former on the substrate (1) thereof, made up of the doped zone (P) of the substrate whereto the detector is connected, called the first doped zone, of a second doped zone (P) formed within this substrate and of a gate electrode $G_{RAN}$ arranged between these two zones, in that it comprises means for biasing, in operation, this second transistor alternatingly into the linear and locked modes of operation, and in that it comprises a second gate electrode $G_{SC2}$ applied onto the substrate and means for applying, in operation, a voltage to this gate in accordance with a ramp which is regularly variable in time, eventually once or a plurality of times within the time interval separating two successive transfers of the signal from the transition into the reader.

4. Photonic detector according to claim 3, characterized in that the second gate electrode $G_{SC2}$ is placed laterally of the gate electrode $G_{RAN}$ between the two P zones.

5. Photonic detector according to claim 3, characterized in that the second gate electrode $G_{SC2}$ is placed on the other side of the gate electrode $G_{RAN}$ with respect to the second P zone.

6. Photonic detector according to claim 3, characterized in that the voltage ramp is linearly variable.

7. Photonic detector according to any of claims 1 to 6, characterised in that it consists of a photovoltaic diode.

8. Image pickup target, characterized in that it comprises at least one detector according to any of claims 1 to 7.

**Patentansprüche**

1. Photonendetektor mit einer Festkörper-Ladungsüberführungs-Lesevorrichtung und dessen Signal in die Lesevorrichtung $G_{(CCD)}$ eingespeist wird durch einen Übergang, der aus einem MOS-Transistor ($P$, $G_C$, $G_{ST}$) besteht, wobei die in der Lesevorrichtung auftretenden Überführungsladungen das entgegengesetzte Vorzeichen wie diejenigen dieses Signals aufweisen, und versehen mit Einrichtungen, die einen Strom $I_{SC}$ erzeugen, der aus Ladungen von demselben Vorzeichen wie die Überführungsladungen gebildet ist, sowie mit Einrichtungen zur Einspeisung dieses Stromes in den Übergang, dadurch gekennzeichnet, daß die Einrichtungen, welche den Strom $I_{SC}$ erzeugen, durch einen zweiten MOS-Transistor gebildet sind, der in geeigneter Weise gepolt sowie in dasselbe Substrat wie die Lesevorrichtung integriert und neben dem vorerwähnten angeordnet ist.

2. Photonendetektor nach Anspruch 1, dadurch gekennzeichnet, daß die den Strom $I_{SC}$ erzeugende Einrichtung aus einem zweiten MOS-Transistor besteht, die neben dem vorerwähnten auf dem Substrat (1) desselben angeordnet sowie gebildet ist durch diejenige dotierte Zone (P) des Substrats, mit welcher der Detektor verbunden ist und die als erste dotierte Zone bezeichnet wird, aus einer zweiten im diesem Substrat gebildeten dotierten Zone (P) sowie aus einer zwischen diesen zwei Zonen angeordneten Gate-Zone $G_{SC}$, und daß er Mittel enthält, um diesen zweiten MOS-Transistor im Betrieb im Sättigungszustand zu halten.

3. Photonendetektor nach Anspruch 1, dadurch gekennzeichnet, daß die den Strom $I_{SC}$ erzeugende Einrichtung aus einem zweiten MOS-Transistor gebildet ist, welcher neben dem erstgenannten auf dem Substrat (1) desselben angeordnet sowie gebildet ist durch diejenige dotierte Zone (P) des Substrats, mit welcher der Detektor verbunden ist und die als erste dotierte Zone bezeichnet wird, durch eine zweite dotierte Zone P, welche in diesem Substrat gebildet ist, sowie durch eine Gate-Elektrode $G_{RAN}$, die zwischen diesen zwei Zonen angeordnet ist, und daß er Mittel enthält, um im Betrieb diesen zweiten Transistor abwechselnd in das lineare Arbeitsgebiet und in das gesperrte Arbeitsgebiet zu polarisieren und daß er eine zweite Gate-Elektrode $G_{SC2}$, die auf das Substrat aufgebracht ist, und Mittel enthält, um im Betrieb an dieses Gate eine Spannung gemäß einer sich mit der Zeit regelmäßig ändernden Rampe anzulegen, gegebenenfalls einmal oder mehrere Male in dem Zeitintervall, das zwei aufeinanderfolgende Signalüberführungen vom Übergang zur Lesevorrichtung trennt.

4. Photonendetektor nach Anspruch 3, dadurch gekennzeichnet, daß die zweite Gate-Elektrode $G_{SC2}$ neben der Gate-Elektrode $G_{RAN}$ zwischen den zwei P-Zonen angeordnet ist.

5. Photonendetektor nach Anspruch 3, dadurch gekennzeichnet, daß die zweite Gate-Elektrode $G_{SC2}$ bezogen auf die zweite P-Zone auf der anderen Seite der Gate-Elektrode $G_{RAN}$ angeordnet ist.

6. Photonendetektor nach Anspruch 3, dadurch gekennzeichnet, daß die Spannungsrampe sich linear verändert.

7. Photonendetektor nach einem der Ansprüche 1 bis 6, dadurch gekennzeichnet, daß er aus einer photovoltaischen Diode besteht.

8. Bildaufnahmetarget, dadurch gekennzeichnet, daß es wenigstens einen Detektor nach einem der Ansprüche 1 bis 7 enthält.

FIG_1

(a) E₁ CCD/N

(b) E₁ CCD/P

FIG_2

(a) E₁ CCD/N

(b) E₁ CCD/P

FIG_3

(a) $I_{SC}$ E₁ CCD/N

(b) $I_{SC}$ E₁ CCD/P

FIG_4

E₂ E₁ $G_{SC}$ $G_C$ $G_{ST}$ $G_T$ $G_{CCD}$ P P N $V_{sub}$ 1

## FIG_5

$\phi_S$

$I_{SC}$  $I_D$  $I_i$

## FIG_6

$V_{RAN}$  E1  
$G_{RAN}$  $G_{SC2}G_C$  $G_{ST}$  $G_T$  $G_{CCD}$

P  P  1

$V_{sub}$

## FIG_8

$V_{(GSC)}$  $T_i$

$V_{(GT)}$

$V_{(RAN)}$

$t_0$  $t_1$  $t_2$

## FIG_9

$V_{RAN}$  $G_{SC2}$  E1  
$G_{RAN}$  $G_C$  $G_{ST}$  $G_T$  $G_{CCD}$

P  P  1

2

$V_{sub}$

# FiG_7

$E_1$

$V_{RAN}$  $G_{RAN}$  $G_{SC2}$  $G_C$  $G_{ST}$  $G_T$  $G_{CCD}$

(a) $t=t_0$

$\phi_S$

(b)

$\phi_S$

ID

Ii

(c) $t=t_1$

$\phi_S$

$\}Q_0$  $\}Q_0-Q_D$

(d) $t=t_2$

$\phi_S$

$\}Q_0-Q_D$

3